Europäisches Patentamt

(19) European Patent Office

Office européen des brevets

(11) Publication number: **0 211 413**
**A2**

## (12) EUROPEAN PATENT APPLICATION

(21) Application number: **86110627.6**

(22) Date of filing: **31.07.86**

(51) Int. Cl.⁴: **H 01 J 37/32**
**C 23 C 14/32**

(30) Priority: **09.08.85 US 764443**

(43) Date of publication of application:
**25.02.87 Bulletin 87/9**

(84) Designated Contracting States:
**CH DE FR GB IT LI NL**

(71) Applicant: **THE PERKIN-ELMER CORPORATION**
**761 Main Avenue**
**Norwalk Connecticut 06859-0074(US)**

(72) Inventor: **Howard, Thomas A.**
**2632 Ilisbury Avenue South**
**Minneapolis Minnesota 55408(US)**

(72) Inventor: **Nurkkala, Paul H.**
**8230 Washburn Avenue South**
**Bloomington Minnesota 55431(US)**

(72) Inventor: **Vergason, Gary E.**
**3121 State Highway 7**
**Excelsior Minnesota 55331(US)**

(74) Representative: **Patentanwälte Grünecker, Kinkeldey,**
**Stockmair & Partner**
**Maximilianstrasse 58**
**D-8000 München 22(DE)**

(54) Arc ignition device.

(57) There is disclosed for a vacuum arc plasma generating system an ignition device that includes an elongated metallic member of length L with an inner edge juxtaposed a distance D from the edge of the target surface of the cathode. An insulating member with a bridging surface is formed preferably of a material such as boron nitride and is interposed such that the bridging surface connects between the ignitor member and the edge of the target surface. The ignitor member and insulating member may be ring-shaped to surround a circular target surface. The inner edge of the ignitor member preferably is formed of a multiplicity of teeth in contact with the bridging surface. An electrically conducting film is deposited on the bridging surface. A simple electrical connection is disposed between the ignitor member and the anode of the plasma system, making the ignitor member a supplemental anode. In one preferred embodiment the length L is sufficiently large and the distance D is sufficiently small for the conducting film to evaporate upon imposition of the d.c. arc voltage between the cathode and anode, thereby initiating the arc without the need for an additional starter voltage power supply.

FIG. 1

# ARC IGNITION DEVICE

This invention relates to a novel anode ignition device and process for starting an arc in plasma apparatus, particularly of the type employed in vacuum arc coating processes.

## Background of the Invention

Arc plasma generators have a variety of designs and applications including, for example, systems that produce coatings by vaporization of material from a cathode target heated by an arc. Such coating systems are disclosed in U.S. Patent Nos. 3,625,848 and 3,836,451 to A.A. Snaper and U.S. Patent Nos. 3,783,231 and 3,793,179 to L. Savlev, et al.

One problem of concern in such systems is stabilization of the arc on the cathode, i.e., stabilization of the cathode spot. For example the aforementioned U.S. Patent No. 3,793,179 describes a shield 21 extending around the cathode 9 with a gap 22 between the shield and cathode which is claimed to preclude transition of the cathode to the non-evaporation surface of the cathode.

U.S. Patent No. 4,430,184 to W.M. Mularie teaches the use of a confinement ring 24 contacting the target 16, the ring being composed of a material having certain characteristics to confine the cathode spot to the target surface of the cathode. The material is specified to have

-1-

a secondary emission ratio less than one at the mean energies of the arc (generally 20-100 electron volts), and should further have a surface energy less than that of the evaporated cathode material. Boron nitride is an example.

Yet another approach is disclosed in U.S. Patent No. 4,448,659 to C. F. Morrison, Jr. In this patent the arc confinement ring 14 is made of magnetically permeable material and is in direct contact with the target 10.

The above-described cathodes with their confinement rings have not provided for starting or initiating an arc. Therefore, several types of separate starting systems are used. One such system is a high voltage spark supply as disclosed in aforementioned U.S. Patent No. 3,625,848, in which spark supply 20 is applied between cathode 15 and a separate electrode 22 proximate to the cathode. The high voltage starter is turned off once the arc is initiated. The arc is then maintained with a direct current supply of low voltage (e.g., 30 volts) and high current (e.g., 200 amperes).

Another common starter method is illustrated in U.S. Patent No. 3,793,179, mentioned above with respect to stabilizing the cathode spot. That patent teaches the use of a movable trigger electrode 29. An electromagnet armature 30 and a return spring 34 control the trigger electrode to momentarily contact the cathode 9 for starting the arc under the applied arc voltage.

Yet another known method is to vaporize a special wire in the vacuum chamber by applying a suitable current thereto. The vapor creates an initial arc path which is then sustained by the normal arc voltage.

The above-described arc initiation methods have substantial shortcomings. The spark method, also commonly used in other types of plasma generators, generally involves at least 1000 volts, and generally 10,000 volts, and creates radio-frequency interference in electronic devices including computers used to control the apparatus during coating operations. The trigger electrode is generally operated through complex mechanisms including solenoids or pneumatic drives. If the trigger electrode requires sealing of a mechanical entry through the wall of the vacuum coating chamber there are binding and leakage problems with attendant arcing and pitting. The vaporizable wire can be used only once in each setup. None of these methods has proven to be fully reliable and often several attempts are necessary before a stable arc is formed or, quite commonly, an operation must be aborted due to non-ignition.

One reason for difficult starting is that, in the vacuum apparatus, initially there is little ionizable material in the potential arc path. This problem is pointed out by Alexander S. Gilmour, Jr. and David L. Lockwood in "Pulsed Metallic-Plasma Generators", Proceedings of the IEEE, 60, 977 (August 1972). The authors describe several methods including the high voltage pulse and the mechanical contacting methods discussed above, as well as a laser pulse method and a titanium hydride igniter.

Gilmour, et al., additionally disclose the use of a

-3-

conductive film on an insulator surface that is located between an ignitor electrode and the cathode. Application of a current pulse of a few hundred volts with a capacitor discharge vaporizes the film to eject an ignition plume that leads to the establishment of the arc that then is sustained by the separate arc power supply. A second source of power separate from the arc voltage supply is required; a capacitive discharge system is disclosed to serve this purpose.

Therefore, an object of the present invention is to provide a novel, reliable anode ignition device for vacuum plasma generating apparatus.

Another object is to provide a novel vacuum arc anode ignition device capable of reliably and repeatedly initiating the arc without need for a separate ignition power source.

A further object is to provide improved vacuum coating apparatus having a simple, low cost arc ignition system.

## Brief Description of the Invention

The foregoing and other objectives are achieved in a vacuum arc plasma generating system according to the present invention by an ignition device that includes an elongated metallic ignitor member of length L with an inner edge juxtaposed a distance D from the edge of the target surface of the cathode. An insulating member with a bridging surface is formed preferably of a material such as boron nitride and is interposed such that the bridging surface connects between the ignitor member and the edge of

-4-

the target surface. The ignitor member and insulating member may be ring-shaped to surround a circular target surface. The inner edge of the ignitor member preferably is formed of a multiplicity of teeth in contact with the bridging surface. An electrically conducting film is deposited on the bridging surface. A simple electrical connection is disposed between the ignitor member and the anode of the plasma system, making the ignitor member a supplemental anode. The length L is sufficiently large and the distance D is sufficiently small for the conducting film to evaporate upon imposition of the d.c. arc voltage between the cathode and anode, thereby initiating the arc without the need for an additional starter voltage power supply.

## Brief Description of the Drawings

Fig. 1 is a cutaway view of an arc deposition apparatus including an ignitor device according to the present invention.

Fig. 2 is a face view of a cathode incorporating an ignition device according to the present invention.

## Detailed Description of the Invention

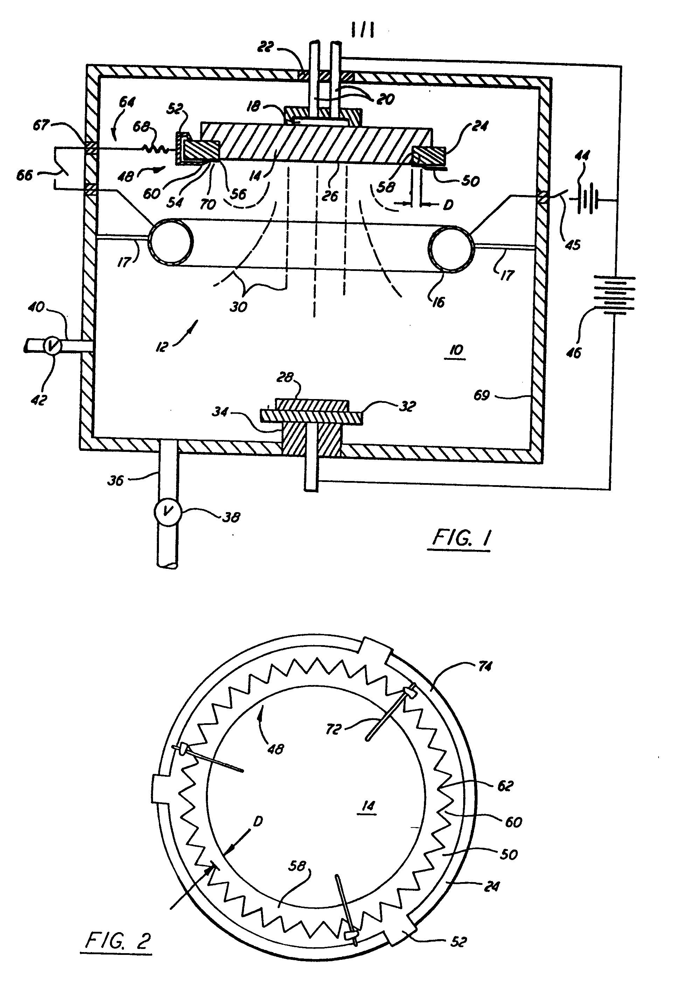

An ignition device according to the present invention is especially suited for apparatus used for producing coatings such as of titanium nitride by vacuum cathodic arc discharge physical vapor deposition ("arc deposition"). Such process and appropriate apparatus are described in detail in aforementioned U.S. Patents Nos. 3,625,848, 3,793,179 and 4,430,184. In one typical embodiment utilized in the present invention, shown in Fig. 1, a vacuum chamber 10 contains a beam gun 12 having a cathode 14 of target source material. A ring anode 16 connected to chamber 10 by insulated mounts 17 serves as the principal anode for the arc discharge to cathode 14. The cathode is mounted to the chamber with a system that includes a water coolant chamber 18 and ducts 20 connected to chamber 10 with an insulator 22. An insulating member 24 in the form of a ring surrounds the target surface 26 of the cathode. In a preferred embodiment insulating member 24 serves as a confinement ring and is formed, for example, of boron nitride as taught in U.S. Patent No. 4,430,184, which confines the cathode spot of the arc to target surface 26 and provides further important advantages as described hereinbelow. Ring anode 16 may be formed of copper tubing or the like.

Substrate 28 to be coated is placed in the beam path 30 of beam gun 12, typically about 25 cm from cathode 14, using an electrically conductive mounting 32 on a high voltage insulator bracket 34 extending through chamber wall 69. A vacuum is drawn through a conduit 36 connected to appropriate vacuum pumps (not shown) known in the art. The chamber is maintained at about 1 millitorr absolute pressure with an inflow of appropriate gas such as nitrogen or argon through a pipe 40. Valve 42 in the pipe may be turned off when the desired pressure is reached.

For an arc deposition system a d.c. power source 44 of the common type is used having a "drooping" characteristic, i.e., an open circuit voltage of about two to three times of the arc operating voltage. Typically the open circuit voltage is less than about 100 volts, giving an operating voltage between about 20 and 50 volts, and current is from about 30 to 200 amperes. Power source 44 is applied between the anode 16 and cathode 14 through a power switch 45. The resulting arc discharge causes beam 30 of source material to be emitted with maximum concentration perpendicular to target surface 26. The beam consists of primarily ions and some neutral atoms, along with electrons. A negative voltage (10 to 2000 volts) source 46 applied to substrate 28 to be coated enhances deposition of the particles, particularly on surfaces that are not facing directly at the source material.

As an example, for the production of a titanium nitride coating, the cathode source used is a titanium disc about 10 cm in diameter. The chamber is maintained at about 1 millitor pressure with nitrogen gas which reacts with the titanium during the deposition process to produce the titanium nitride coating. The system is operated, for example, for about 15 minutes to produce a coating on substrate surface 28 having a thickness between about 1 and 30 microns. However, coatings from about 0.1 microns to about 1.0 mm thick are typical.

According to the present invention an ignition device 48, also shown in further detail in Fig. 2, is comprised of a metallic anode ignitor member 50 in combination with insulating member 24. The ignitor member may be shaped from sheet metal such as stainless steel, copper or molybdenum. As shown in Fig. 2 ignitor member 50 may be in the form of a ring retained by C-shaped spring clips 52 on the outer surface of insulating member 24. Any other clamping means may be used, such as a second ring on the opposite side of the insulating member with a series of arcuately spaced bolts retained in holes bored through the rings and insulating member. A small gap of distance D is provided between the inner edge 54 (Fig. 1) of ignitor member 50 and the outer edge 56 of target surface 26, exposing a bridging surface 58 of insulating member 24. The ignitor member has a circumferential length L, measured along inner edge 54. An important feature of one embodiment of the present invention is that length L be quite large and distance D be quite small, as will become evident from the discussion below. A suitable thickness of ignitor 50 is 0.8 mm.

Inner edge 54 of ignitor number 50 should be in contact with bridging surface 58. This is achieved in the embodiment shown in Fig. 2 by means of a multiplicity of teeth 60 formed in inner edge 54 that are curved toward bridging surface 58 (Fig. 1) for the tips 62 to contact surface 58. In such case distance D is measured between the points of tips 62 and edge 54, and distance L is measured along the envelope of tips 62.

An electrical connection 64 is made between anode ignitor member 50 and principal anode 16. This includes an ignitor circuit switch 66 and optional resistance element 68 of up to about 15 ohms. Switch 66 may be located outside the chamber by leading connection 64 through an insulator 67 in chamber wall 69. Other than the switch and the resistance element no other electrical components or devices are necessary, and connection 64 is a simple electrical connection. Thus no separate source of electrical power, such as a starter power supply, capacitive discharge apparatus or the like is included. As used herein and in the claims the term "simple electrical connection" may include a switch and/or an electrical resistance element but expressly excludes any additional power source for starting the arc.

For the purpose of initiating the arc, bridging surface 58 has a thin electrically conducting film 70 deposited thereon, having a thickness between about 0.05 microns and about 50 microns preferably between about 0.1 microns and about 10 microns. In the case of coating apparatus such as shown in Fig. 1 such a coating film will deposit during a coating operation on virtually all surfaces in coating chamber 10 including bridging surface 58. Thus a prior coating operation with the apparatus is a highly convenient means to apply film 70 which may consist, for example, of titanium nitride. When the arc voltage is initially applied with switch 66 closed the voltage is applied across film 70.

According to the present invention distance D is relatively small, for example from about 1 mm to about 10 mm and preferably from about 3 mm to about 5 mm. Additionally, length L preferably should be relatively large, for example greater than about 5 cm and preferably greater than about 10 cm. Generally length L is sufficiently large and distance D sufficiently small such that at least a portion of film 70 is evaporated by a current pulse when the arc voltage source is applied by closing switch 45 between anode 16 and cathode 14, switch 66 being previously set in its closed position. The evaporated film material then is ionized under the arc voltage to provide an arc path and thus initiate the arc. With ignitor member 50 in the form of a ring or other shape conforming in close proximity to cathode 14, member 50 also

-9-

apparently acts as an interim anode to help establish and support the initial arc discharge. When the arc is established the main anode 16 takes over at least a portion of the arc discharge. The initial current pulse is limited by resistance 68.

With the arc initiated, substrate 28 is coated in the normal manner. Simultaneously bridging surface 58 receives replenishment of film 70 of the coating material. Switch 66 is opened almost immediately (about 1 millisecond, automatically through an arc sensor as desired) after the arc is initiated, transferring the arc discharge to principal anode 16. As an alternative switch 66 may be left closed to provide for instantaneous reignition if there be termination of the arc and, also, to improve arc operation by ignitor member 50 acting as a supplementary anode.

When the substrate is coated as desired the power switch 45 is opened and the substrate may be replaced with another to be coated. When the apparatus is readied again with the desired gas, and switch 66 is reset closed, power switch 45 is then closed, and the arc automatically restarts by way of the newly evaporated film material and the coating process is repeated. The cycle may be further repeated for as many substrates as desired or until cathode target 14 or insulating member 24 is replaced.

A fresh insulating member may be coated with an initial film by any known or desired method. For example it may be placed in a coating apparatus at any convenient, unused location during a previous coating operation using another insulating member. Thus ignition devices may be perpetuated.

In an embodiment of the present invention shown in Fig. 2 at least one and preferably three or more finger members 72 are used for starting the arc when a new or fresh insulating member is installed. These finger members are attached to ignitor member 50, for example, by means of spring clasps 74 such that the finger members extend radially inward and contact target surface 26 near outer edge 58 of the cathode. The finger members may be formed, for example, of 0.8 mm wide extensions of the ring material or may be formed of other convenient conductive material. The finger members may be wires about 0.3 cm to 3 cm long (e.g. 2.5 cm) and 0.5 mm to 3 mm diameter or strips of similar cross sectional area. The resistivity, number and dimensions of the finger members are coordinated such that they are heated to evaporation when arc voltage source 44 is applied (with switch 45 closed). The evaporated finger material initiates the arc as described above for the film.

The finger members need only be put in place whenever the arc apparatus is started up with an insulating member 24 that has no film 70 deposited on bridging surface 58. After the first deposition run the film will have been deposited and subsequent initiations of the arc can be accomplished without the fingers as described above.

As indicated hereinabove the insulating member is preferably formed of the special material defined in the Mularie U.S. Patent No. 4,430,184. One reason is that such material, particularly boron nitride, is found to facilitate arc initiation without the arc lingering on film 70. Apparently, due to low surface free energy and low secondary emission coefficient of the boron nitride, it is not wet by the metal film nor reduced by the action of the arc. Thus upon each use the film readily separates from bridging surface 58 and is dispersed to leave a clean surface in preparation for re-coating. Thus film thickness is under control and repetitive cycles of redepositing film and restarting the arc are allowed without excessive buildup or arcing damage to the bridging surface.

On the other hand, if an ordinary insulating material such as aluminum oxide is used, the action of the vaporizing current will ultimately destroy the insulator by repeating the large currents along the permanent conductive paths on the bridging surface.

Thus, it has been discovered that the insulating member should have material characteristics such as outlined in the Mularie patent that result in confining the cathode spot to the target surface. In particular, the material should have a secondary emission ratio less than one at the mean energies of the electrons or other charged particles of the arc incident on the material (typically 20-100ev). The emission ratio is defined as the number of electrons emitted by the material per primary charged particle incident thereon. Additionally the material should have a surface energy less than that of the evaporated target material so that the target material will not wet the insulating material. According to the Mularie patent, for most metals that may be used for target materials, boron nitride (BN) has these suitable characteristics and, therefore is especially desirable for the insulating member.

It should be emphasized that such a material as boron nitride, surprisingly, may be an important and integral part of the arc starting system, in addition to subsequently playing its role (as in the Mularie patent) in confining the arc after starting. With such insulating material length L may even be relatively small, for example 5 mm, and in such case the insulating member need not be used as a confinement ring but rather may be of comparable dimension (L). It is preferred, however, that L be larger as indicated above, to assure sufficient vaporization of the film and have the ignitor member act reliably as a supplemental starting anode.

While the invention has been described above in detail with reference to specific embodiments, various changes and modifications which fall within the spirit of the invention and scope of the appended claims will become apparent to those skilled in this art. The invention is therefore only intended to be limited by the appended claims or their equivalents.

## What is claimed is

1.  In a vacuum plasma generating apparatus containing an anode and a cathode and being operative to sustain an electrical arc between the anode and a target surface of the cathode under an imposed arc voltage, an ignition device for initiating the arc comprising;

an elongated metallic ignitor member of length L with an edge juxtaposed a distance D from the edge of the target surface;

an insulating member with a bridging surface, interposed such that the bridging surface connects between the ignitor member and the edge of the target surface;

a simple electrical connection disposed between the ignitor member and the anode; and

an electrically conducting film deposited on the bridging surface;

The length L being sufficiently large and the distance D being sufficiently small for at least a portion of the conducting film to evaporate upon imposition of the arc voltage and thereby initiate the arc.

2.  An ignition device according to Claim 1 wherein the length L is greater than about 5 cm and the distance D is between about 1 mm and about 10 mm.

3.  An ignition device according to Claim 1 wherein the ignitor member and the insulating member substantially surround the target surface.

4.  An ignition device according to Claim 3 wherein the target surface is circular and the ignitor member and the insulating member are ring shaped.

5. An ignition device according to Claim 1 wherein the inner edge is formed of a multiplicity of teeth in contact with the bridging surface.

6. An ignition device according to Claim 1 wherein the plasma generating apparatus is adapted for coating substrates with cathode material evaporated by the arc from the target surface, and the conducting film on the bridging surface is deposited from a portion of the evaporated cathode material.

7. An ignition device according to Claim 1 wherein the simple electrical connection includes a resistance element of up to about 15 ohms.

8. An ignition device according to Claim 1 wherein the simple electrical connection includes switching means to open the electrical connection immediately after the arc is initiated.

9. An ignition device according to Claim 1 wherein the insulating member is configured to surround the target surface and is composed of an insulating material having (a) a secondary emission ratio less than one at the mean energies of the charged particles of the arc and (b) a surface energy less than that of the evaporated target material to confine the cathode to the target surface.

-15-

10. An ignition device according to Claim 9 wherein the insulating material comprises boron nitride.

11. A vacuum arc coating apparatus comprising:

an anode;

a cathode having a target surface thereon;

an elongated metallic ignitor member of length L with edge juxtaposed a distance D from the edge of the target surface;

an insulating member with a bridging surface, interposed such that the bridging surface connects between the ignitor member and the edge of the target surface;

a simple electrical connection disposed between the ignitor member and the anode; and

means to provide an arc voltage to sustain an electrical arc between the anode and the target surface such that the arc evaporates cathode material from the target surface whereby an electrically conductive film is deposited on the bridging surface;

the length L being sufficiently large and the distance D being sufficiently small for the conducting film to evaporate upon a subsequent imposition of the arc voltage after termination thereof and thereby reinitiate the arc upon the subsequent imposition.

12. A coating apparatus according to Claim 11 further comprising separate starter means to initiate the arc in the absence of the conducting film on the bridging surface.

-16-

13. A coating apparatus according to Claim 12 wherein the separate starter means comprises at least one electrically conductive and replaceable finger member connected to the ignitor member and extending to the target surface in electrical contact therewith, the finger member being evaporable upon imposition of the arc voltage to initiate the arc in the absence of the conducting film on the bridging surface.

14. A coating apparatus according to Claim 11 wherein the insulating member is configured to surround the target surface in contact therewith and is composed of an insulating material having (a) secondary emission ratio less than one at the mean energies of the charged particles of the arc and (b) a surface energy less than that of the evaporated target material to confine the cathode to the target surface.

15. A coating apparatus according to Claim 14 wherein the insulating material comprises boron nitride.

16. A coating apparatus according to Claim 11 wherein the ignitor member is configured to surround the target surface and is composed of magnetically permeable material to confine the cathode spot to the target surface.

17. A coating apparatus according to Claim 16 wherein the ignitor member has a transverse gap therein to prevent induced current flow in the ignitor member.

-17-

18.   A coating apparatus according to Claim 11 wherein the arc voltage has an open circuit value less than about 100 volts.

19.   A vacuum arc coating apparatus comprising:

an anode;

a cathode having a circular target surface thereon;

a ring shaped metallic ignitor member of circumference L substantially circumscribing the target surface, with an inner edge spaced a distance D from the edge of the target surface, the inner edge being formed of a multiplicity of teeth;

an insulating member with a bridging surface, interposed such that the bridging surface connects between the ignitor member and the edge of the target surface with the teeth being in contact with the bridging surface, the insulating member being composed of an insulating material having (a) secondary emission ratio less than one at the mean energies of the charged particles of the arc and (b) a surface energy less than that of the evaporated target material to confine the cathode to the target surface.

a simple electrical connection disposed between the ignitor member and the anode;

means to provide an arc voltage to sustain an electrical arc between the anode and the target surface such that the arc evaporates cathode material from the target surface whereby an electrically conductive film is deposited on the bridging surface; and

at least one electrically conductive and replaceable finger member connected to the ignitor member and extending to the target surface in electrical contact therewith, the finger member being evaporable upon imposition of the arc

-18-

voltage to initiate the arc in the absence of the conducting film on the bridging surface;

the length being sufficiently large and the distance D being sufficiently small for the conducting film to evaporate upon a subsequent imposition of the arc voltage after a termination thereof and thereby reinitiate the arc upon the subsequent imposition.

20. A process for initiating an arc in a vacuum arc coating apparatus comprising in sequence the steps of:

(a) providing:

an elongated metallic ignitor member of length L with an edge juxtaposed a distance D from the edge of the target surface;

an insulating member with a bridging surface, interposed such that the bridging surface connects between the ignitor member and the edge of the target surface; and

a simple electrical connection disposed between the ignitor member and the anode;

the length L being sufficiently large and the distance D being sufficiently small for at least a portion of the electrically conducting film deposited on the bridging surface according to step (c) to evaporate upon imposition of an arc voltage and thereby initiate the arc;

(b) imposing the arc voltage;

(c) initiating an electrical arc between the anode and the target surface such that the arc evaporates cathode material from the target surface whereby an electrically conductive film is deposited on the bridging surface;

(d) reimposing the arc voltage, thereby evaporating the conducting film and reinitiating the arc.

-19-

21. A process according to Claim 20 wherein the insulating member is configured to surround the target surface and is composed of an insulating material having (a) a secondary emission ratio less than one at the mean energies of the charged particles of the arc and (b) a surface energy less than that of the evaporated target material to confine the cathode to the target surface.

22. A process according to Claim 21 wherein the insulating material comprises boron nitride.

-20-

*FIG. I*

*FIG. 2*